# EUROPEAN PATENT APPLICATION

(11) **EP 4 773 752 A1**
(43) Date of publication of application: **08.07.2026**
(21) Application number: 25817400.2
(22) Date of filing: 08.04.2025
(51) Int. Cl.: H10B 12/00

(54) **SEMICONDUCTOR STRUCTURE AND MANUFACTURING METHOD THEREFOR**

(30) Priority: 12.09.2024 CN 202411282682
(71) Applicant: CXMT Corporation, Hefei, Anhui 230601 (CN)
(72) Inventor: ZHANG, Junchao, Hefei, Anhui 230601 (CN); WANG, Dan, Hefei, Anhui 230601 (CN)
(74) Representative: Gulde & Partner
(86) International application number: PCT/CN2025/087719
(87) International publication number: WO 2026/056255

(57) **Abstract**

A manufacturing method for a semiconductor structure and a semiconductor structure are provided. The manufacturing method includes steps as follows: A substrate is provided; a stacked structure that is formed by alternately stacking multiple semiconductor material layers and multiple insulating material layers is formed on the substrate; a channel region stacked layer and an initial gate pillar are formed in the stacked structure, where the initial gate pillar includes at least an initial gate conductive layer and an initial gate dielectric layer, and the initial gate pillar has two first sidewalls that are disposed opposite to each other and that are respectively in contact with two adjacent channel region stacked layers and a second sidewall that is not in contact with the channel region stacked layers; and at least the gate dielectric layer and the gate conductive layer that are located on the second sidewall are removed, to form a target gate pillar, where the target gate pillar has two opposite third sidewalls that are respectively in contact with two adjacent channel region stacked layers, and a gate conductive layer having a first length and a gate dielectric layer having a second length that are located on each of the third sidewalls, and the first length is less than the second length. A semiconductor structure with high performance can be obtained according to the manufacturing method.

## Description

This application is based on and claims priority to Chinese Patent Application No. 202411282682.X, filed with the China National Intellectual Property Administration on September 12, 2024 and entitled "SEMICONDUCTOR STRUCTURE AND MANUFACTURING METHOD FOR SEMICONDUCTOR STRUCTURE". The above-referenced application is incorporated herein by reference in its entirety.

### TECHNICAL FIELD

Embodiments of the present disclosure relate to the field of semiconductor technologies, and in particular, to a semiconductor structure and a manufacturing method for a semiconductor structure.

### BACKGROUND

The development of a dynamic memory (DRAM) seeks performance indicators such as a high speed, a high integrated density, and low power consumption. With miniaturization of the structure size of a semiconductor device, a technical barrier encountered by an existing structure becomes increasingly obvious. Therefore, on the basis of the existing structure, more novel structures are developed, which are advantageous means to break existing technical barriers.

The appearance of a three-dimensional dynamic random access memory (3D DRAM), in particular, a 3D DRAM including a multilayer horizontal cell (Multilayer Horizontal Cell, MHC), which usually includes multiple transistors stacked on a substrate, meets the foregoing requirement.

However, in a process of manufacturing the multilayer horizontal unit in narrow space, especially in a process of manufacturing a horizontal storage transistor, a processing difficulty is high, and performance of the manufactured horizontal storage transistor also needs to be improved.

### SUMMARY

According to a first aspect of embodiments of the present disclosure, a manufacturing method for a semiconductor structure is provided and includes steps as follows: A substrate is provided; a stacked structure that is formed by alternately stacking multiple semiconductor material layers and multiple insulating material layers is formed on the substrate; a channel region stacked layer and an initial gate pillar that extend in a first direction perpendicular to a surface of the substrate are formed in the stacked structure, where the initial gate pillar includes at least an initial gate conductive layer and an initial gate dielectric layer, and the initial gate pillar has two first sidewalls that are disposed opposite to each other and that are respectively in contact with two adjacent channel region stacked layers and a second sidewall that is not in contact with any channel region stacked layer; and at least the initial gate dielectric layer and the initial gate conductive layer that are of the initial gate pillar and that are located on the second sidewall are removed, to form a target gate pillar, where the target gate pillar includes two third sidewalls that are disposed opposite to each other and that are respectively in contact with two adjacent channel region stacked layers, and a gate conductive layer having a first length and a gate dielectric layer having a second length that are located on each of the third sidewalls, the gate dielectric layer is located between the gate conductive layer and the channel region stacked layer, the first length is less than the second length, length directions of the first length and the second length are both in a second direction, and the second direction is parallel to the surface of the substrate and a surface of each of the third sidewalls.

In some embodiments, formation, in the stacked structure, of the channel region stacked layer extending in the first direction perpendicular to a surface of the substrate includes a step as follows: Multiple first through holes are formed in the stacked structure, where the multiple first through holes extend in the first direction and penetrate through the stacked structure, and are arranged at intervals in a third direction parallel to the surface of the substrate, the stacked structure between adjacent first through holes serves as the channel region stacked layer, and the third direction and the second direction are perpendicular to each other.

In some embodiments, formation, in the stacked structure, of the initial gate pillar extending in a first direction perpendicular to a surface of the substrate includes steps as follows: A sacrificial material is fully filled in a first through hole, to form a first sacrificial pillar; a first mask with a first opening is formed on the stacked structure, and etching is performed along the first opening to form a second through hole in the first sacrificial pillar, where the second through hole penetrates through the stacked structure, and at least in the third direction, a size of the second through hole is basically the same as a size of the first through hole; and the initial gate dielectric layer, the initial gate conductive layer, and a first insulating layer are formed in the second through hole in sequence, to form the initial gate pillar, where in the third direction, the initial gate pillar has two opposite first sidewalls that are respectively in contact with two adjacent channel region stacked layers, and in the second direction, the initial gate conductive layer that is of the initial gate pillar and that is located on the first sidewall has a third length. The third length is greater than the first length, and the third length is greater than or equal to the second length.

In some embodiments, after the second through hole is formed and before the initial gate pillar is formed in the second through hole, the manufacturing method further includes a step as follows: Ion implantation is performed on the channel region stacked layer through the second through hole, to form an oppositely doped channel region.

In some embodiments, removal of at least the initial gate dielectric layer and the initial gate conductive layer that are of the initial gate pillar and that are located on the second sidewall, to form a target gate pillar includes steps as follows: A second mask with a second opening is formed on the stacked structure, and etching is performed along the second opening to form a third through hole in the first sacrificial pillar, where the third through hole penetrates through the stacked structure, and exposes the second sidewall of the initial gate pillar; and at least the initial gate dielectric layer and the initial gate conductive layer that are located on the second sidewall are removed through the third through hole, to form the target gate pillar, where in the third direction, the target gate pillar has the two third sidewalls that are disposed opposite to each other and that are respectively in contact with two adjacent channel region stacked layers.

In some embodiments, after the third through hole is formed and before at least the initial gate conductive layer located on the second sidewall is removed through the third through hole, the manufacturing method further includes a step as follows: Ion implantation is performed on the stacked structure adjacent to the channel region stacked layer through the third through hole, to form a lightly doped drain region.

In some embodiments, after the target gate pillar is formed, the manufacturing method further includes a step as follows: A second insulating layer is filled in the third through hole.

In some embodiments, after the target gate pillar is formed and the second insulating layer is filled in the third through hole, the manufacturing method further includes a step as follows: An auxiliary gate layer is formed in the third through hole, where the auxiliary gate layer is located at two ends of the gate conductive layer, the two ends are disposed opposite to each other in the second direction, and a work function of the auxiliary gate layer is less than a work function of the gate conductive layer.

In some embodiments, after the target gate pillar is formed, the manufacturing method further includes a step as follows: The gate conductive layers on the two third sidewalls that are located on two sides, of the same channel region stacked layer, disposed opposite to each other in the third direction and that are in contact with the channel region stacked layers are connected, to form a word line structure.

In some embodiments, after the stacked structure is formed, the manufacturing method further includes a step as follows: A bit line structure and a capacitor structure are formed, where the bit line structure and the capacitor structure are respectively located at two ends of the channel region stacked layer, and the two ends are disposed opposite to each other in the second direction.

According to a second aspect of embodiments of the present disclosure, a semiconductor structure is provided and includes: a substrate; a stacked structure, formed on the substrate by alternately stacking multiple semiconductor material layers and multiple insulating material layers, the stacked structure further including at least a channel region stacked layer extending in a first direction perpendicular to a surface of the substrate; and a target gate pillar, penetrating through the stacked structure in the first direction, the target gate pillar including two third sidewalls that are disposed opposite to each other and that are respectively in contact with two adjacent channel region stacked layers, and a gate conductive layer having a first length and a gate dielectric layer having a second length that are located on each of the third sidewalls, where the gate dielectric layer is located between the gate conductive layer and the channel region stacked layer, the first length is less than the second length, length directions of the first length and the second length are both in a second direction, and the second direction is parallel to the surface of the substrate and a surface of each of the third sidewalls.

In some embodiments, the channel region stacked layer and the target gate pillar are alternately arranged in a third direction, and the third direction is parallel to the surface of the substrate and perpendicular to the second direction.

In some embodiments, the target gate pillar further includes a first insulating layer, and the gate conductive layers located on the two third sidewalls that are of the same target gate pillar and that are disposed opposite to each other in the third direction are isolated through the first insulating layer.

In some embodiments, the channel region stacked layer further includes an oppositely doped channel region, and the oppositely doped channel region is located in a region in which the channel region stacked layer is in contact with the third sidewall of the target gate pillar. The stacked structure further includes a lightly doped drain region, the lightly doped drain region is adjacent to two sides that are of the channel region stacked layer and that are disposed opposite to each other in the second direction, and an ion doping type of the lightly doped drain region is opposite to that of the oppositely doped channel region.

In some embodiments, the semiconductor structure further includes an auxiliary gate layer, the auxiliary gate layer being located on two sides that are of the gate conductive layer of the target gate pillar on the third sidewall and that are disposed opposite to each other in the second direction, where a work function of the auxiliary gate layer is less than a work function of the gate conductive layer.

In some embodiments, the semiconductor structure further includes a word line structure that connects the gate conductive layers on the two third sidewalls that are located on two sides, of the same channel region stacked layer, disposed opposite to each other in the third direction and that are in contact with the channel region stacked layers.

In some embodiments, the semiconductor structure further includes a bit line structure and a capacitor structure, the bit line structure and the capacitor structure being respectively located on the two sides that are of the channel region stacked layer and that are disposed opposite to each other in the second direction.

### BRIEF DESCRIPTION OF DRAWINGS

FIG. 1 is a schematic diagram of providing a substrate according to an example embodiment;
FIG. 2 is a schematic diagram of forming a stacked structure according to an example embodiment;
FIG. 3 is a schematic diagram of forming a first through hole and a channel region stacked layer according to an example embodiment;
FIG. 4 is a schematic diagram of forming a first sacrificial pillar according to an example embodiment;
FIG. 5 is a schematic diagram of forming a second through hole according to an example embodiment;
FIG. 6 is a schematic diagram of forming an oppositely doped channel region according to an example embodiment;
FIG. 7 is a schematic diagram of forming an initial gate pillar according to an example embodiment;
FIG. 8 is a schematic diagram of forming a third through hole according to an example embodiment;
FIG. 9 and FIG. 10 are schematic diagrams of forming a lightly doped drain region stacked layer and removing, through a third through hole, an initial gate dielectric layer and an initial gate conductive layer that are of an initial gate pillar and that are located on a second sidewall according to an example embodiment;
FIG. 11 is a schematic diagram of forming a second insulating layer according to an example embodiment;
FIG. 12 is a schematic diagram of forming a second insulating layer according to another example embodiment;
FIG. 13 is a schematic diagram of forming an auxiliary gate layer and a second insulating layer according to still another example embodiment; and
FIG. 14 is a schematic diagram of forming a bit line structure and a capacitor structure according to an example embodiment.

### DESCRIPTION OF EMBODIMENTS

The technical solutions of the present disclosure are further described below in detail with reference to the accompanying drawings and the embodiments. Although example implementation methods of the present disclosure are shown in the accompanying drawings, it should be understood that the present disclosure may be implemented in various forms without being limited by the implementations described herein. Instead, these implementations are provided to develop a more thorough understanding of the present disclosure and to fully convey the scope of the present disclosure to a person skilled in the art.

In the following paragraphs, the present disclosure is described more specifically by way of example with reference to the accompanying drawings. The advantages and features of the present disclosure will be clearer from the following description and claims. It should be noted that the accompanying drawings are presented in a highly simplified form and are not to exact scale, and are merely intended to conveniently and clearly assist in describing the embodiments of the present disclosure.

It may be understood that meanings of "on", "over", and "above" in the present disclosure should be understood in the broadest sense, so that "on" means that it is "on" something with no intermediate feature or layer (that is, directly on something), and further includes the meaning that it is "on" something with an intermediate feature or layer.

In the embodiments of the present disclosure, the terms "first", "second", "third", and the like are intended to distinguish between similar objects but do not necessarily describe a specific order or sequence.

In the embodiments of the present disclosure, the term "layer" refers to a material part including a region having a thickness. The layer may extend over the whole of a lower or upper structure, or may have a range smaller than the range of the lower or upper structure. In addition, the layer may be a region of a homogeneous or heterogeneous continuous structure whose thickness is less than the thickness of a continuous structure. For example, the layer may be located between the top surface and the bottom surface of the continuous structure, or the layer may be located between any horizontal surface pair at the top surface and the bottom surface of the continuous structure. The layer may extend horizontally, vertically, and/or along an inclined surface. The layer may include multiple sublayers.

It should be noted that the technical solutions described in the embodiments of the present disclosure may be randomly combined when there is no conflict.

In a related technology, a process of manufacturing a 3D memory structure generally needs to form a stack of a semiconductor material and an insulating material, and then form a storage unit structure, such as a storage transistor, a storage capacitor, a bit line, and a word line, based on the semiconductor material. For formation of a word line structure in the 3D memory structure, there are generally two main-stream formation structures: One word line structure controls transistor structures in the same vertical column in a direction perpendicular to a substrate, and the other word line structure controls transistor structures in the same horizontal column in a direction parallel to a substrate. The two word line structures have respective advantages and disadvantages. The first type of word line structure and a manufacturing method thereof are mainly described in the present disclosure. The inventor of this application finds that, in a process of forming a vertical word line structure in a stack in a 3D memory structure, because space size is limited, a gate oxide layer is thinned, and the word line structure serves as both a gate of a transistor and a channel region of a transistor structure and is connected to an overlap between the word line structure and a drain, which easily generates a gate-induced drain leakage (gate-induced drain leakage, GIDL) effect, and severely, affects operating performance of a storage transistor, a storage cell structure, and even an entire memory device.

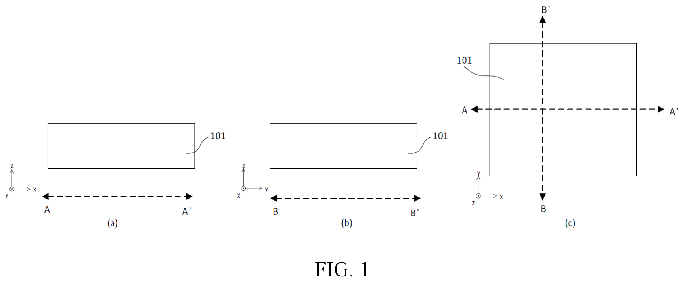

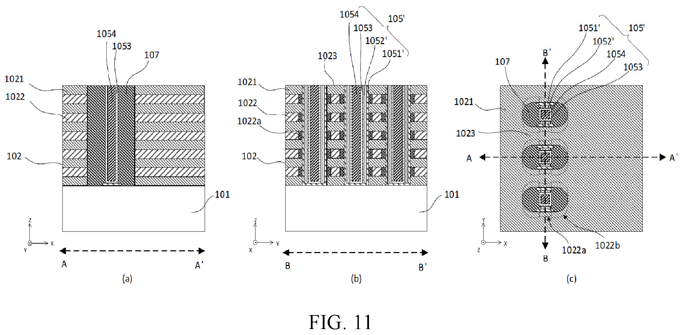

In view of the above technical problems, the present disclosure provides a manufacturing method for a semiconductor structure and a semiconductor structure. The semiconductor structure and the manufacturing method for a semiconductor structure provided in the present disclosure with examples are specifically described below with reference to FIG. 1 to FIG. 14. FIG. 1 to FIG. 11 are schematic diagrams of steps and structures in a manufacturing method for a semiconductor structure according to an example embodiment of the present disclosure. FIG. 11 to FIG. 14 are schematic diagrams of a semiconductor structure according to multiple example embodiments of the present disclosure.

In an example embodiment of the present disclosure, a substrate 101 is provided. Referring to FIG. 1, (c) in FIG. 1 is a top view facing the substrate 101 in a direction perpendicular to a surface of the substrate 101 (that is, a direction opposite to a Z direction), and (a) in FIG. 1 and (b) in FIG. 1 are respectively schematic diagrams along a cross-section A-A' and along a cross-section B-B' in (c) in FIG. 1. The cross-section A-A' is parallel to an X direction and perpendicular to a Y direction, and the cross-section B-B' is parallel to the Y direction and perpendicular to the X direction.

The substrate 101 may be made of at least one of the following materials: silicon, germanium, silicon on insulator (SOI), stacked silicon on insulator (SSOI), stacked silicon-germanium on insulator (S-SiGeOI), silicon-germanium on insulator (SiGeOI), germanium on insulator (GeOI), and other semiconductor materials or III-V materials. In an example embodiment of the present disclosure, the substrate 101 is made of monocrystalline silicon.

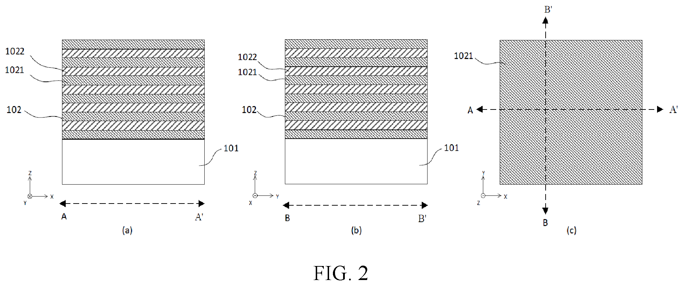

In an example embodiment of the present disclosure, a stacked structure 102 formed by alternately stacking multiple semiconductor material layers 1022 and multiple insulating material layers 1021 is formed on the substrate 101. As shown in FIG. 2, (c) in FIG. 2 is a top view facing the substrate 101 in a direction perpendicular to a surface of the substrate 101 (that is, a direction opposite to the Z direction), and (a) in FIG. 2 and (b) in FIG. 2 are respectively schematic diagrams along a cross-section A-A' and along a cross-section B-B' in (c) in FIG. 2. The cross-section A-A' is parallel to the X direction and perpendicular to the Y direction, and the cross-section B-B' is parallel to the Y direction and perpendicular to the X direction. In some embodiments, the multiple semiconductor material layers 1022 and the multiple insulating material layers 1021 are interspersed alternately, that is, as shown in (a) in FIG. 2 or (b) in FIG. 2, one single-layer insulating material layer 1021 is interspersed between any two adjacent single-layer semiconductor material layers 1022, and one single-layer semiconductor material layer 1022 is interspersed between any two adjacent single-layer insulating material layers 1021. In the stack structure 102, each of the insulating material layers 1021 or each of the semiconductor material layers 1022 is closer to the substrate. This is not specifically limited in the present disclosure.

In some embodiments, the semiconductor material layer 1022 may be made of at least one or any combination of the following materials: silicon, germanium, silicon germanium (SiGe), III-V materials, indium gallium zinc oxide (IGZO), and a two-dimensional material. In an example embodiment of the present disclosure, the semiconductor material layer 1022 is made of silicon. In some embodiments, the insulating material layer 1021 may be made of at least one or any combination of the following materials: silicon oxide, silicon nitride, silicon oxynitride, silicon oxycarbide, silicon carbonitride, and silicon oxycarbonitride. In an example embodiment of the present disclosure, the insulating material layer 1021 is made of silicon oxide.

In an example embodiment of the present disclosure, a method for forming the stacked structure 102 includes steps as follows: A monocrystalline silicon (Si) surface of the substrate 101 serves as an initial base layer, and a silicon-silicon germanium (Si-SiGe) alternately stacked initial stacked structure is grown on the substrate 101 according to an epitaxial growth method. A germanium source gas may be added in an epitaxial growth process of a silicon layer to form a silicon germanium layer as a sacrificial layer. Subsequently, the silicon germanium sacrificial layer is removed through selective lateral etching, and an insulating material is deposited or grown between the silicon layers to replace the silicon germanium layer, to form the insulating material layer 1021.

In some embodiments, in the stacked structure 102, a quantity of insulating material layers 1021 is 1 more than a quantity of semiconductor material layers 1022, and both the quantities are greater than or equal to 4. In some other embodiments, in the stacked structure 102, a quantity of insulating material layers 1021 is the same as a quantity of semiconductor material layers 1022, and both the quantities are greater than or equal to 4. In some embodiments, a bottom layer in the stacked structure 102, that is, a single layer that is in direct contact with the substrate 101, is the insulating material layer 1021, so as to ensure that an underlying storage unit structure subsequently formed is isolated from the substrate 101. In some embodiments, a top layer in the stacked structure 102, that is, a single layer that is farthest from the substrate 101, is the insulating material layer 1021, so as to protect the underlying storage unit structure from easy loss in a subsequent process.

In some embodiments, before or after the stacked structure 102 is formed on the substrate 101, the method further includes a step as follows: An isolation layer (not shown in the figure) is formed on another region of the substrate 101, where the isolation layer has a height equal to the height of the stacked structure 102.

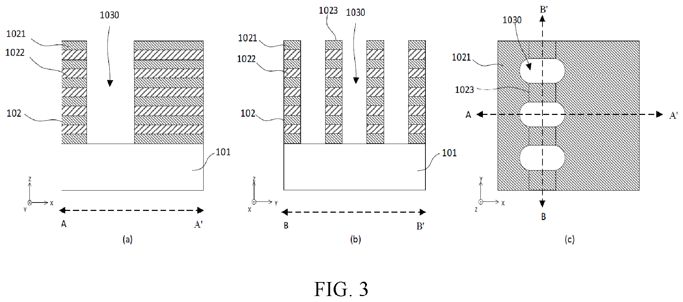

In an example embodiment of the present disclosure, multiple first through holes 1030 are formed in the stacked structure 102, the first through holes 1030 extend in the Z direction and penetrate through the stacked structure 102, the multiple first through holes 1030 are arranged at intervals in the Y direction, and the stacked structure 102 between adjacent first through holes 1030 serves as a channel region stacked layer 1023. As shown in FIG. 3, (c) in FIG. 3 is a top view facing the substrate 101 in a direction perpendicular to a surface of the substrate 101 (that is, a direction opposite to the Z direction), and (a) in FIG. 3 and (b) in FIG. 3 are respectively schematic diagrams along a cross-section A-A' and along a cross-section B-B' in (c) in FIG. 3. The cross-section A-A' is parallel to the X direction and perpendicular to the Y direction, and the cross-section B-B' is parallel to the Y direction and perpendicular to the X direction.

In some embodiments, spacings between adjacent first through holes 1030 are equal. In some embodiments, a cross-sectional shape of the first through holes 1030 in a direction parallel to the surface of the substrate 101 is a rectangle, a corner rectangle, or a quasi-rectangle having arc edges at two ends in the X direction and having straight edges at two ends in the Y direction, so as to ensure that the channel region stacked layer 1023 between the adjacent first through holes 1030 has a flat sidewall surface.

In some embodiments, the stacked structure 102 may be etched through a photolithography process, to form the first through holes 1030. Specifically, a photoresist mask layer may be formed on the stacked structure 102. A pattern of the first through holes 1030 is formed in the photoresist mask layer through exposure development, and then dry etching is performed to etch the stacked structure 102 along the pattern, to form the first through holes 1030. In some embodiments, before the photoresist mask layer is coated, the method further includes steps as follows: An antireflection layer and a hard mask layer (not shown in the figure) are formed on a top surface of the stacked structure 102, and both layers are removed after the first through holes 1030 are formed.

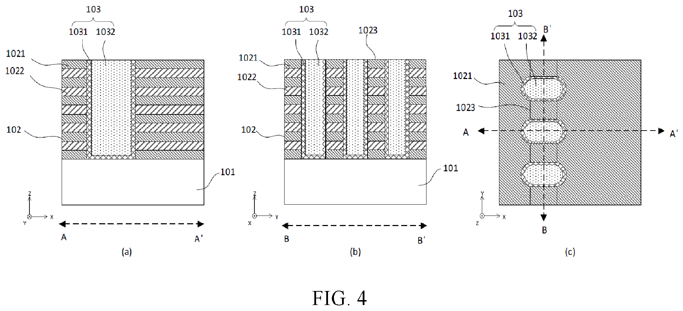

In an example embodiment of the present disclosure, after the first through holes 1030 are formed, a sacrificial material is fully filled in a first through hole to form a first sacrificial pillar 103. As shown in FIG. 4, (c) in FIG. 4 is a top view facing the substrate 101 in a direction perpendicular to a surface of the substrate 101 (that is, a direction opposite to the Z direction), and (a) in FIG. 4 and (b) in FIG. 4 are respectively schematic diagrams along a cross-section A-A' and along a cross-section B-B' in (c) in FIG. 4. The cross-section A-A' is parallel to an X direction and perpendicular to a Y direction, and the cross-section B-B' is parallel to the Y direction and perpendicular to the X direction. Specifically, in some embodiments, a first sacrificial material layer 1031 is first deposited in each of the first through holes 1030 to cover an inner wall (including a sidewall and a bottom wall) of the first through hole 1030, and a second sacrificial material layer 1032 is then deposited on a surface of the first sacrificial material layer 1031 to fully fill the first through hole 1030, where the first sacrificial material layer 1031 and the second sacrificial material layer 1032 jointly constitute the first sacrificial pillar 103. The first sacrificial material layer 1031 covers the sidewall and the bottom wall of the first through hole 1030, that is, also covers a sidewall of the channel region stacked layer 1023 and the surface of the substrate 101 that are separated by the first through hole 1030, so that in a subsequent etching process, a specific buffering and protective effect is provided for the sidewall of the channel region stacked layer 1023 and the surface of the substrate 101. In some other embodiments, the first sacrificial pillar 103 further includes a third sacrificial material layer (not shown in the figure) located between the first sacrificial material layer 1031 and the second sacrificial material layer 1032.

In some embodiments, the first sacrificial material layer 1031 and the second sacrificial material layer 1032 may be made of at least one or any combination of the following materials: silicon oxide, aluminum oxide, silicon nitride, silicon oxynitride, silicon oxycarbide, silicon carbonitride, silicon oxycarbonitride, and polysilicon. In an example embodiment of the present disclosure, the first sacrificial material layer 1031 is made of silicon oxide, and the second sacrificial material layer 1032 is made of polysilicon.

In some embodiments, a deposition method for the first sacrificial material layer 1031 and the second sacrificial material layer 1032 may be at least one of the following deposition methods: chemical vapor deposition (CVD), low-pressure chemical vapor deposition (LPCVD), plasma enhanced chemical vapor deposition (PECVD), ultra-high vacuum chemical vapor deposition (UHVCVD), flowable chemical vapor deposition (FCVD), direct liquid injection chemical vapor deposition (DLICVD), rapid thermal chemical vapor deposition (RTCVD), microwave plasma assisted chemical vapor deposition (MPCVD), organometallic chemical vapor deposition (MOCVD), and atomic layer deposition (ALD).

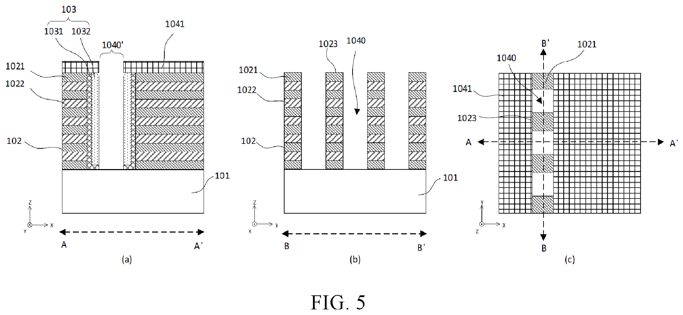

In an example embodiment of the present disclosure, after the first sacrificial pillar 103 is formed, a first mask 1041 with a first opening 1040' is formed on the stacked structure 102, a second through hole 1040 is formed in the first sacrificial pillar 103 by etching along the first opening 1040', and the second through hole 1040 penetrates through the stacked structure 102. In addition, at least in the Y direction, a size of the second through hole 1040 is basically the same as a size of the first through hole 1030. As shown in FIG. 5, (c) in FIG. 5 is a top view facing the substrate 101 in a direction perpendicular to a surface of the substrate 101 (that is, a direction opposite to the Z direction), and (a) in FIG. 5 and (b) in FIG. 5 are respectively schematic diagrams along a cross-section A-A' and along a cross-section B-B' in (c) in FIG. 5. The cross-section A-A' is parallel to the X direction and perpendicular to the Y direction, and the cross-section B-B' is parallel to the Y direction and perpendicular to the X direction.

In some embodiments, from a perspective of a cross-section parallel to the surface of the substrate 101, the second through hole 1040 is located at a position near the middle of the first sacrificial pillar 103, which is equivalent to or approximately equivalent to sharing a central axis. It should be noted that a direction of the "central axis" herein is a direction perpendicular to the surface of the substrate 101. In some embodiments, the second through hole 1040 exposes sidewalls of the channel region stacked layer 1023 on two sidewalls disposed opposite to each other in the Y direction. In some embodiments, a size of the second through hole 1040 in the X direction is less than a size of the first through hole 1030 in the X direction, and is greater than or equal to a size of the channel region stacked layer 1023 in the X direction.

In some embodiments, the first opening 1040' is in a form of a single strip whose long side extends in the Y direction, to expose a top surface of a part of the first sacrificial pillar 103 and a top surface of all the channel region stacked layers 1023. In some embodiments, a forming method for the first opening 1040' may be etching the first mask 1041 through a photolithography process, to form the first opening 1040'. Specifically, a photoresist mask layer may be formed on the first mask 1041. A pattern of the first opening 1040' is formed in the photoresist mask layer through exposure development, and then dry etching is performed to etch the first mask 1041 along the pattern, to form the first opening 1040'. In some embodiments, before the photoresist mask layer is coated, the method further includes steps as follows: An antireflection layer (not shown in the figure) is formed on a top surface of the first mask 1041, and the antireflection layer and the first mask are removed after the first opening 1040' is formed.

In some embodiments, the first mask 1041 may be made of any one or a combination of silicon nitride, silicon oxynitride, silicon oxycarbide, silicon carbonitride, and silicon oxycarbonitride. In some embodiments, a deposition method for the first mask 1041 may be at least one of the following deposition methods: chemical vapor deposition (CVD), low-pressure chemical vapor deposition (LPCVD), plasma enhanced chemical vapor deposition (PECVD), ultra-high vacuum chemical vapor deposition (UHVCVD), flowable chemical vapor deposition (FCVD), direct liquid injection chemical vapor deposition (DLICVD), rapid thermal chemical vapor deposition (RTCVD), microwave plasma assisted chemical vapor deposition (MPCVD), organometallic chemical vapor deposition (MOCVD), and atomic layer deposition (ALD).

In some embodiments, an etching process for forming the second through hole 1040 is basically the same as the description of the etching process for forming the first through hole 1030 in the foregoing embodiment, and is not described herein again. However, different from forming the first through hole 1030 in the foregoing embodiment, after the second through hole 1040 is formed, the first mask 1041 is temporarily not removed.

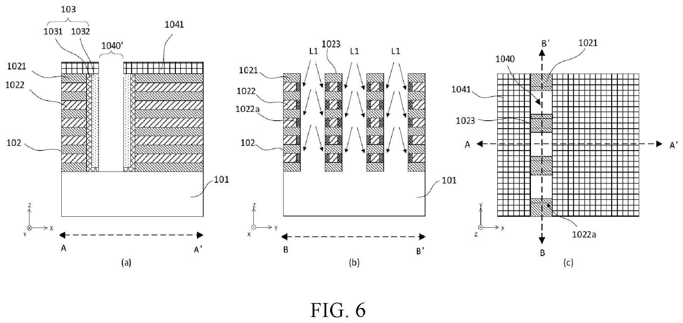

In an example embodiment of the present disclosure, after the second through hole 1040 is formed, ion implantation L1 is performed on the channel region stacked layer 1023 through the second through hole 1040, to form an oppositely doped channel region 1022a. As shown in FIG. 6, (c) in FIG. 6 is a top view facing the substrate 101 in a direction perpendicular to a surface of the substrate 101 (that is, a direction opposite to the Z direction), and (a) in FIG. 6 and (b) in FIG. 6 are respectively schematic diagrams along a cross-section A-A' and along a cross-section B-B' in (c) in FIG. 6. The cross-section A-A' is parallel to an X direction and perpendicular to a Y direction, and the cross-section B-B' is parallel to the Y direction and perpendicular to the X direction. Specifically, from the second through hole 1040 to the sidewall of the exposed channel region stacked layer 1023, the first mask 1041 and the top-layer insulating material layer 1021 exposed by the first opening 1040' serve as masks, and the ion implantation L1 is performed at an inclined angle, so as to form the oppositely doped channel region 1022a on two sidewalls that are of each channel region stacked layer 1023 and that are disposed opposite to each other in the Y direction. It should be noted that the "inclined angle" herein is inclined in a reverse direction of the Y direction or the Y direction with the Z direction (or a reverse direction thereof) as an axis.

In some embodiments, an ion in the ion implantation L1 may be a boron ion.

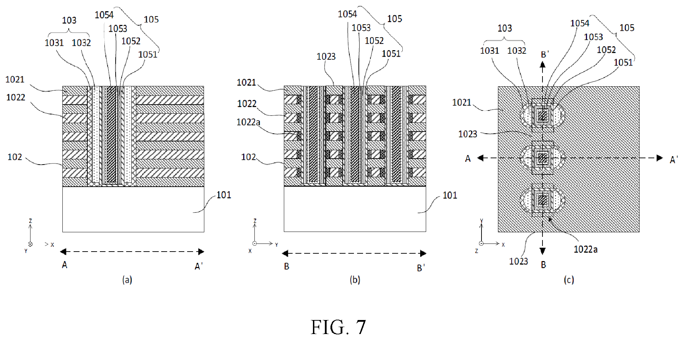

In an example embodiment of the present disclosure, after the oppositely doped channel region 1022a is formed, an initial gate dielectric layer 1051, an initial gate conductive layer 1052, and a first insulating layer are formed in the second through hole 1040 in sequence to form an initial gate pillar 105. In the Y direction, the initial gate pillar 105 has two opposite first sidewalls that are respectively in contact with two adjacent channel region stacked layers 1023, and in the X direction, the initial gate conductive layer 1052 that is of the initial gate pillar 105 and that is located on the first sidewall has a third length D3. As shown in FIG. 7, (c) in FIG. 7 is a top view facing the substrate 101 in a direction perpendicular to a surface of the substrate 101 (that is, a direction opposite to the Z direction), and (a) in FIG. 7 and (b) in FIG. 7 are respectively schematic diagrams along a cross-section A-A' and along a cross-section B-B' in (c) in FIG. 7. The cross-section A-A' is parallel to an X direction and perpendicular to a Y direction, and the cross-section B-B' is parallel to the Y direction and perpendicular to the X direction. In some embodiments, the first insulating layer includes multiple insulating sublayers. In an example embodiment of the present disclosure, the first insulating layer includes a first insulating sublayer 1053 and a second insulating sublayer 1054, where the first insulating sublayer 1053 is located on an outer circumference of the second insulating sublayer 1054. In some embodiments, in the X direction, a sidewall of the initial gate dielectric layer 1051 in contact with the channel region stacked layer 1023 covers at least a surface of the oppositely doped channel region 1022a.

In some embodiments, the first insulating sublayer 1053 and the second insulating sublayer 1054 may be made of at least one or any combination of the following materials: silicon oxide, silicon nitride, silicon oxynitride, silicon oxycarbide, silicon carbonitride, and silicon oxycarbonitride. In an example embodiment of the present disclosure, the first insulating sublayer 1053 is made of silicon nitride, and the second insulating sublayer 1054 is made of silicon oxide. In some embodiments, a deposition method for the first insulating layer may be at least one of the following deposition methods: chemical vapor deposition (CVD), low-pressure chemical vapor deposition (LPCVD), plasma enhanced chemical vapor deposition (PECVD), ultra-high vacuum chemical vapor deposition (UHVCVD), flowable chemical vapor deposition (FCVD), direct liquid injection chemical vapor deposition (DLICVD), rapid thermal chemical vapor deposition (RTCVD), microwave plasma assisted chemical vapor deposition (MPCVD), organometallic chemical vapor deposition (MOCVD), and atomic layer deposition (ALD).

In some embodiments, the initial gate dielectric layer 1051 may be made of silicon oxide, and the initial gate conductive layer 1052 may be made of titanium nitride or tungsten. In an example embodiment of the present disclosure, the initial gate dielectric layer 1051 is formed according to an in-situ steam generation (ISSG) process, and the initial gate conductive layer 1052 is formed according to an atomic layer deposition (ALD) process.

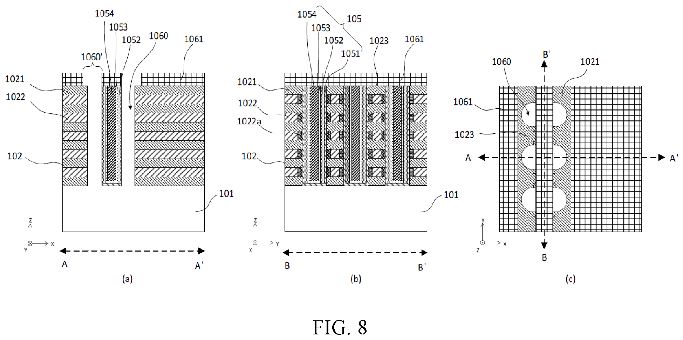

In an example embodiment of the present disclosure, after the initial gate pillar 105 is formed, a second mask 1061 with a second opening 1060' is formed on the stacked structure 102, a third through hole 1060 is formed in the first sacrificial pillar 103 by etching along the second opening 1060', and the third through hole 1060 penetrates through the stacked structure 102, and exposes a second sidewall of the initial gate pillar 105, where the second sidewall of the initial gate pillar 105 is not in contact with the channel region stacked layer 1023. As shown in FIG. 8, (c) in FIG. 8 is a top view facing the substrate 101 in a direction perpendicular to a surface of the substrate 101 (that is, a direction opposite to the Z direction), and (a) in FIG. 8 and (b) in FIG. 8 are respectively schematic diagrams along a cross-section A-A' and along a cross-section B-B' in (c) in FIG. 8. The cross-section A-A' is parallel to the X direction and perpendicular to the Y direction, and the cross-section B-B' is parallel to the Y direction and perpendicular to the X direction. In some embodiments, in a plane direction parallel to the surface of the substrate 101, a position of the second opening 1060' is adjacent to two ends of the position of the first opening 1040' in the foregoing embodiment in the X direction. In some embodiments, the first sacrificial pillar 103 remaining after the second through hole 1040 is formed in the foregoing embodiment is removed through the third through hole 1060. In some embodiments, the initial gate dielectric layer 1051 that is of the initial gate pillar 105 and that is located on the second sidewall is further removed while the third through hole 1060 is formed, as shown in (a) in FIG. 8.

In some embodiments, from a perspective of a cross-section parallel to the surface of the substrate 101, the third through hole 1060 is located at positions that are of the first sacrificial pillar 103 and that are close to two ends in the X direction, that is, the third through hole 1060 is adjacent to two ends of the initial gate pillar 105 in the X direction. In some embodiments, the third through hole 1060 is disposed symmetrically on a plane in which central axes of the multiple initial gate pillars 105 arranged in the Y direction are jointly located. In some embodiments, the third through hole 1060 at least exposes the sidewall of the stacked structure 102 adjacent to the channel region stacked layer 1023.

In some embodiments, the second opening 1060' is in a form of two strips whose long sides extend in the Y direction, to expose the top surface of the remaining first sacrificial pillar 103 and the top surface of the stacked structure 102 adjacent to the channel region stacked layer 1023. In some embodiments, a forming method for the second opening 1060' may be the same as the forming method for the first opening 1040' in the foregoing embodiment, and is not described herein again.

In some embodiments, descriptions of a material and a forming method of the second mask 1061 may be basically the same as those of the material and the forming method of the first mask 1041 in the foregoing embodiments, and are not described herein again.

In some embodiments, an etching process for forming the third through hole 1060 is basically the same as the descriptions of the etching process for forming the first through hole 1030 in the foregoing embodiments. This is not described herein again. However, different from forming the first through hole 1030 in the foregoing embodiments, after the third through hole 1060 is formed, the second mask 1061 is temporarily not removed.

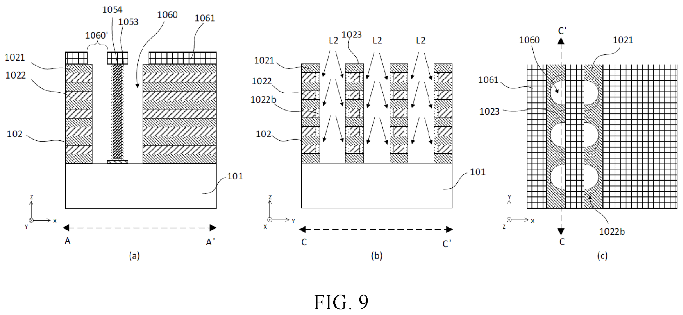

In an example embodiment of the present disclosure, after the third through hole 1060 is formed, ion implantation L2 is performed on the stacked structure 102 adjacent to the channel region stacked layer 1023 through the third through hole 1060, to form a lightly doped drain region 1022b (LDD). As shown in FIG. 9, (c) in FIG. 9 is a top view facing the substrate 101 in a direction perpendicular to a surface of the substrate 101 (that is, a direction opposite to the Z direction), and (a) in FIG. 9 and (b) in FIG. 9 are respectively schematic diagrams along a cross-section A-A' and along a cross-section C-C' in (c) in FIG. 9. The cross-section A-A' is parallel to an X direction and perpendicular to a Y direction, and the cross-section C-C' is parallel to the Y direction and perpendicular to the X direction. Specifically, from the third through hole 1060 to a sidewall that is of the stacked structure 102 and that is exposed by the third through hole 1060, the second mask 1061 and the top-layer insulating material layer 1021 exposed by the second opening 1060' serve as masks, and the ion implantation L2 is performed at an inclined angle, so as to form the lightly doped drain region 1022b on the two sidewalls of the stacked structure 102 that are exposed by the third through hole 1060 and that are disposed opposite to each other in at least the Y direction, that is, the lightly doped drain region 1022b is formed on two sidewall surfaces of each semiconductor material layer 1022 in the stacked structure 102 that are exposed by the third through hole 1060 and that are disposed opposite to each other in at least the Y direction, to form a lightly doped drain region stacked layer. It should be noted that the "inclined angle" herein is inclined in a reverse direction of the Y direction or the Y direction with the Z direction (or a reverse direction thereof) as an axis. In some embodiments, the lightly doped drain region 1022b is formed on a partial region in which a sidewall of the stacked structure 102 is exposed by the third through hole 1060. In some other embodiments, the lightly doped drain region 1022b is formed on all regions in which a sidewall of the stacked structure 102 is exposed by the third through hole 1060. It should be noted that both the "partial region" and "all regions" herein refer to a surface region of each semiconductor material layer 1022, and each insulating material layer 1021 exposed by the third through hole 1060 in the stacked structure 102 does not form the lightly doped drain region 1022b.

In some embodiments, a type of a doped ion in the ion implantation L2 is opposite to that in the ion implantation L1 in the foregoing embodiments, and the ion in the ion implantation L2 may be a phosphonium ion or an arsenic ion.

In some embodiments, after the lightly doped drain region 1022b is formed, the method further includes a step as follows: Source drain doping is performed on the stacked structure 102 adjacent to two ends that are of the channel region stacked layer 1023 and that are disposed opposite to each other in the X direction, to form a source drain region, where a type of a doped ion of the source drain region is the same as a type of a doped ion of the lightly doped drain region 1022b.

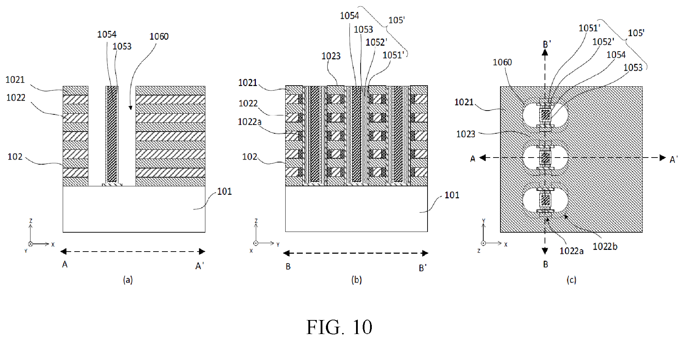

In an example embodiment of the present disclosure, after the lightly doped drain region 1022b is formed, at least the initial gate conductive layer 1052 that is of the initial gate pillar 105 and that is located on the second sidewall is removed along the third through hole 1060, to form a target gate pillar 105'. In the Y direction, the target gate pillar 105' has two third sidewalls that are disposed opposite to each other and that are respectively in contact with two adjacent channel region stacked layers 1023, and a gate conductive layer 1052' having a first length and a gate dielectric layer 1051' having a second length that are located on each of the third sidewalls, where the first length is less than the second length. As shown in FIG. 10, (c) in FIG. 10 is a top view facing the substrate 101 in a direction perpendicular to a surface of the substrate 101 (that is, a direction opposite to the Z direction), and (a) in FIG. 10 and (b) in FIG. 10 are respectively schematic diagrams along a cross-section A-A' and along a cross-section B-B' in (c) in FIG. 10. The cross-section A-A' is parallel to an X direction and perpendicular to a Y direction, and the cross-section B-B' is parallel to the Y direction and perpendicular to the X direction. Specifically, side etching is performed through the wet chemical etching or lateral dry etching from the third through hole 1060 to the second sidewall that is of the initial gate pillar 105 and that is exposed by the third through hole 1060, and at least the initial gate conductive layer 1052 located on the second sidewall is removed.

In some embodiments, because the initial gate dielectric layer 1051 that is of the initial gate pillar 105 and that is located on the second sidewall has been removed in a process of forming the third through hole 1060 in the foregoing embodiment, only the initial gate conductive layer 1052 located on the second sidewall is removed through this time of side etching. In some other embodiments, after the third through hole 1060 is formed in the foregoing embodiment, because the initial gate dielectric layer 1051 that is of the initial gate pillar 105 and that is located on the second sidewall is not removed or partially removed, through this time of side etching, the initial gate dielectric layer 1051 located on the second sidewall is first removed, and then the initial gate conductive layer 1052 located on the second sidewall is removed.

In some embodiments, after the initial gate conductive layer 1052 that is of the initial gate pillar 105 and that is located on the second sidewall is removed through the side etching, a small amount of over etch (over etch) is further performed on the initial gate conductive layer 1052 that is of the initial gate pillar 105 and that is located on the first sidewall in contact with the channel region stacked layer 1023, to obtain the target gate pillar 105'.

In some embodiments, the initial gate conductive layer 1052 that is of the initial gate pillar 105 and that is located on the first sidewall in the foregoing embodiment has a third length in the X direction, and the third length is greater than the first length and greater than or equal to the second length. That is, because of etching of the initial gate dielectric layer 1051 and the initial gate conductive layer 1052 that are of the initial gate pillar 105 and that are located on the second sidewall, the reserved initial gate dielectric layer 1051 and initial gate conductive layer 1052 that are of the initial gate pillar 105 and that are located on the first sidewall are also lost to some extent. Finally, a formed gate conductive layer 1052' that is of the target gate pillar 105' and that is located on the third sidewall is shortened in length in the X direction relative to the original initial gate conductive layer 1052, and a projection overlapping region between the gate conductive layer 1052' and the lightly doped drain region in the Y direction is reduced, thereby reducing a probability of a gate-induced drain leakage (GIDL) effect, reducing impact of GIDL, and further improving operating performance of the memory device.

In an example embodiment of the present disclosure, after the target gate pillar 105' is formed, the second insulating layer 107 is filled in the third through hole 1060. As shown in FIG. 11, (c) FIG. 11 is a top view facing the substrate 101 in a direction perpendicular to a surface of the substrate 101 (that is, a direction opposite to the Z direction), and (a) in FIG. 11 and (b) in FIG. 11 are respectively schematic diagrams along a cross-section A-A' and along a cross-section B-B' in (c) in FIG. 11. The cross-section A-A' is parallel to an X direction and perpendicular to a Y direction, and the cross-section B-B' is parallel to the Y direction and perpendicular to the X direction. In some embodiments, the second insulating layer 107 is fully filled in the third through hole 1060, is located at two opposite ends of the target gate pillar 105' in the X direction, and is in seamless contact with the target gate pillar 105'.

In some embodiments, descriptions of a material and a forming method of the second insulating layer 107 may be the same as those of the material and forming method of the first insulating layer in the foregoing embodiments, and are not described herein again. In an example embodiment of the present disclosure, the second insulating layer 107 is made of silicon oxide. Silicon oxide of the second insulating layer 107 has a low dielectric constant, and when silicon oxide of the second insulating layer 107 covers two ends that are of the gate conductive layer 1052' and that are disposed opposite to each other in the X direction, impact of the GIDL effect caused by band-to-band tunneling (band-to-band tunneling, BTBT) may be further reduced.

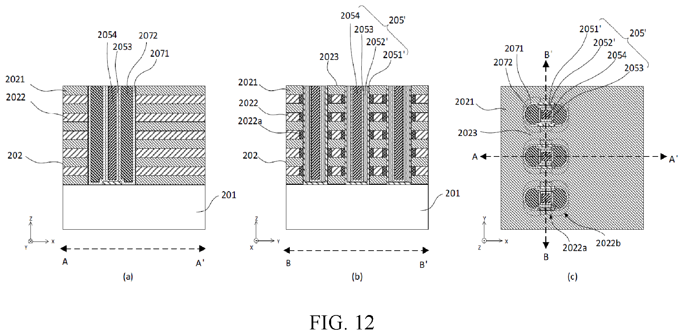

In another example embodiment of the present disclosure, referring to FIG. 12, (c) in FIG. 12 is a top view facing the substrate 101 in a direction perpendicular to a surface of the substrate 201 (that is, a direction opposite to the Z direction), and (a) in FIG. 12 and (b) in FIG. 12 are respectively schematic diagrams along a cross-section A-A' and along a cross-section B-B' in (c) in FIG. 12. The cross-section A-A' is parallel to an X direction and perpendicular to a Y direction, and the cross-section B-B' is parallel to the Y direction and perpendicular to the X direction. A structure basically the same as that shown in FIG. 10 in the foregoing embodiments is provided. Different from the structure and forming steps shown in FIG. 11, in FIG. 12, before the second insulating layer 2072 is fully filled in the third through hole, the following forming step is further included: A third insulating layer 2071 is first formed, to cover an inner wall (including a sidewall and a bottom wall) of the third through hole. The third insulating layer 2071 is located between the second insulating layer 2072 subsequently filled and the substrate 201, the stacked structure 202, and the target gate pillar 205'.

In some embodiments, descriptions of a material and a forming method of the second insulating layer 2072 and the third insulating layer 2071 are the same as descriptions of the material and the forming method of the first insulating layer in the foregoing embodiments, and are not described herein again. In an example embodiment of the present disclosure, the second insulating layer 2072 is made of silicon oxide, and the third insulating layer 2071 is made of silicon nitride. Silicon nitride of the third insulating layer 2071 has a good function of oxygen and water vapor isolation, and can protect the gate conductive layer 2052' and the gate dielectric layer 2051' from oxygen and water vapor in the environment when covering two ends that are located on the gate conductive layer 2052' and the gate dielectric layer 2051' and that are disposed opposite to each other in the X direction, thereby ensuring operating performance of the memory device to some extent.

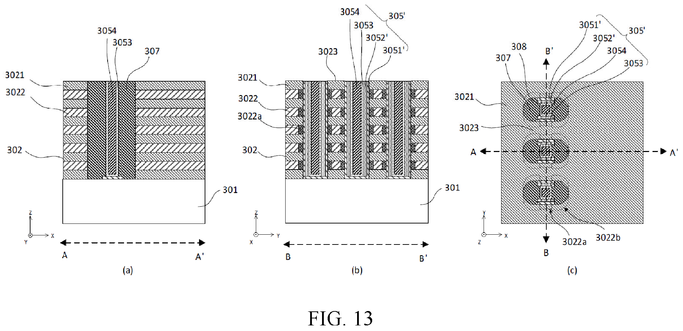

In still another example embodiment of the present disclosure, referring to FIG. 13, (c) in FIG. 13 is a top view facing the substrate 101 in a direction perpendicular to a surface of the substrate 301 (that is, a direction opposite to the Z direction), and (a) in FIG. 13 and (b) in FIG. 13 are respectively schematic diagrams along a cross-section A-A' and along a cross-section B-B' in (c) in FIG. 13. The cross-section A-A' is parallel to an X direction and perpendicular to a Y direction, and the cross-section B-B' is parallel to the Y direction and perpendicular to the X direction. A structure basically the same as that shown in FIG. 10 in the foregoing embodiments is provided. Different from the structure and forming steps shown in FIG. 11, in FIG. 13, before the second insulating layer 307 is fully filled in the third through hole, the following forming step is further included: An auxiliary gate layer 308 is first formed, where the auxiliary gate layer 308 is located at two ends of the gate conductive layer 3052' that is of the target gate pillar 305 and that is on the third sidewall. A work function of the auxiliary gate layer 308 is less than a work function of the gate conductive layer 3052'. Specifically, an auxiliary gate material layer is first formed in the third through hole to cover an inner wall of the third through hole, and then, in addition to positions at two ends that are of the gate conductive layer 3052' and that are disposed opposite to each other in the X direction, an auxiliary gate material layer of another region is etched, and the auxiliary gate material layer reserved serves as the auxiliary gate layer.

In some embodiments, the auxiliary gate layer 308 is made of doped polysilicon, and the gate conductive layer 3052' is made of titanium nitride. Compared with the titanium nitride material, the doped polysilicon has a low work function, and the auxiliary gate layer 308 is located at two ends of the gate conductive layer 3052' that is of the target gate pillar 305 and that is on the third sidewall, which compensates for a problem in the foregoing embodiment that a short gate conductive layer easily causes a large gate resistance and poor electrical signal transmission. In addition, because the auxiliary gate layer 308 is located in a projection overlapping region between the auxiliary gate layer 308 and the lightly doped drain region in the Y direction, the auxiliary gate layer having a low work function may also reduce impact of the GIDL effect to some extent, thereby improving operating performance of the memory device.

In some embodiments, a deposition method for the auxiliary gate layer 308 may be at least one of the following deposition methods: chemical vapor deposition (CVD), low-pressure chemical vapor deposition (LPCVD), plasma enhanced chemical vapor deposition (PECVD), ultra-high vacuum chemical vapor deposition (UHVCVD), flowable chemical vapor deposition (FCVD), direct liquid injection chemical vapor deposition (DLICVD), rapid thermal chemical vapor deposition (RTCVD), microwave plasma assisted chemical vapor deposition (MPCVD), organometallic chemical vapor deposition (MOCVD), and atomic layer deposition (ALD).

In an example embodiment of the present disclosure, after the target gate pillar 105' is formed, the gate conductive layers 1052', on the third sidewalls, of two target gate pillars 105' that are located on two sides, of the same channel region stacked layer 1023, disposed opposite to each other in the Y direction and that are in contact with the channel region stacked layer 1023 are connected, to form a word line structure. Specifically, the word line structures are in a one-to-one correspondence with the channel region stacked layers 1023, and two gate conductive layers 1052' that are closest to the corresponding channel region stacked layer 1023 are connected to each other. A main body of the word line structure is two gate conductive layers 1052' that are close to the same channel region stacked layer 1023, which jointly control turn-on or turn-off of the oppositely doped channel region 1022a located in the same channel region stacked layer 1023.

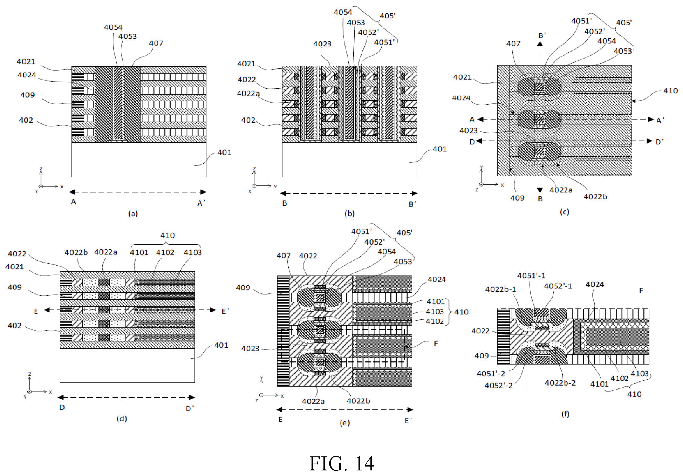

In an example embodiment of the present disclosure, after the stacked structure 102 is formed, the manufacturing method further includes a step as follows: A bit line structure and a capacitor structure are formed, where the bit line structure and the capacitor structure are respectively located at two ends of the channel region stacked layer 1023, and the two ends are disposed opposite to each other in the X direction. Specifically, at one end of the stacked structure 102 in the X direction, a part of a semiconductor material layer 1022 may be removed through selective lateral etching, and then a bit line material is filled, to form the bit line structure. At the other end of the stacked structure 102 in the X direction, a part of the semiconductor material layer 1022 may be removed through selective lateral etching, and then a capacitor material, including a first electrode material, a capacitor dielectric material, and a second electrode material, is filled, to form the capacitor structure. It should be noted that before the capacitor structure is formed, an insulating isolation layer that extends in the X direction and the Z direction and penetrates through the stacked structure 102 needs to be formed in the stacked structure 102, so as to separate the channel region stacked layer 1023 and the semiconductor material layer in the Y direction. Refer to a structural and positional relationship between a bit line structure 409 and a capacitor structure 410 in a stacked structure 402 in (e) in FIG. 14. (c) in FIG. 14 is a top view facing the substrate 101 in a direction perpendicular to a surface of a substrate 401 (that is, a direction opposite to the Z direction). (a) in FIG. 14, (b) in FIG. 14, and (d) in FIG. 14 are respectively schematic diagrams along a cross-section A-A', along a cross-section B-B', and along a cross-section D-D' in (c) in FIG. 14, (e) in FIG. 14 is a schematic diagram along a cross-section E-E' in (d) in FIG. 14, and (f) in FIG. 14 is a partially enlarged schematic diagram of a region F (dashed box) in (e) in FIG. 14. The cross-section A-A' and the cross-section D-D' are parallel to the X direction and perpendicular to the Y direction, the cross-section B-B' is parallel to the Y direction and perpendicular to the X direction, and the cross-section E-E' is perpendicular to the Z direction. The bit line structures 409 are configured to provide or sense, through the semiconductor material layer 4022, induced charges stored in or released from the capacitor structures 410 in the same horizontal layer.

In some embodiments, a forming sequence of the bit line structure 409, the capacitor structure 410, and a channel region stacked layer 4023 may have multiple arrangements. For example, the bit line structure 409 may be first formed, then the capacitor structure 410 is formed, and finally the channel region stacked layer 4023 is formed; or the channel region stacked layer 4023 is first formed, then the bit line structure 409 is formed, and finally the capacitor structure 410 is formed. This is not specifically limited in the present disclosure.

In some embodiments, after a part of the semiconductor material layer is selectively etched laterally, and before the bit line material and/or the capacitor material are/is filled, metal silicification processing is performed on an end surface of the semiconductor material layer reserved and exposed, to correspondingly form a bit line contact layer (not shown in the figure) and/or a capacitor contact layer (not shown in the figure), so as to reduce a contact resistance between the bit line structure and/or the capacitor structure and the semiconductor material layer.

In some embodiments, the method for removing a part of the semiconductor material layer 1022 through selective lateral etching may be wet chemical etching. Specifically, the semiconductor material layer 1022 is selectively etched with an ammonia deionized water mixture (ADM), a potassium hydroxide solution (KOH), or tetramethylammonium hydroxide (TMAH) as a silicon etching solution.

In some embodiments, the bit line structure may be made of one or a combination of titanium nitride, titanium, tungsten, and tungsten nitride. In some other embodiments, the bit line structure may be further made of one or more of molybdenum, ruthenium, copper, platinum, tantalum, or nitrides thereof. In some embodiments, an electrode material in the capacitor structure may be one or a combination of titanium nitride, tantalum nitride, and silicon-doped titanium nitride. A capacitive dielectric material of the capacitor structure may be at least one or a combination of zirconium oxide (ZrO₂) and aluminum oxide (Al₂O₃). In some other embodiments, the capacitive dielectric material may further be at least one or a combination of silicon oxide (SiO₂), hafnium oxide (HfO₂), titanium oxide (TiO₂), tantalum oxide (Ta₂O₅), barium strontium titanate (BST), strontium titanate (STO), and lead zirconate titanate (PZT).

In some embodiments, a forming method for materials of the bit line structure and the capacitor structure may be at least one of the following deposition methods: chemical vapor deposition (CVD), low-pressure chemical vapor deposition (LPCVD), plasma enhanced chemical vapor deposition (PECVD), ultra-high vacuum chemical vapor deposition (UHVCVD), flowable chemical vapor deposition (FCVD), direct liquid injection chemical vapor deposition (DLICVD), rapid thermal chemical vapor deposition (RTCVD), microwave plasma assisted chemical vapor deposition (MPCVD), organometallic chemical vapor deposition (MOCVD), atomic layer deposition (ALD), physical vapor deposition(PCD), and electroplating and sputtering.

In the manufacturing method for a semiconductor structure provided in the present disclosure, on the one hand, the stacked structure is first formed on the substrate, then the first sacrificial pillar is formed in the stacked structure, then the initial gate pillar is formed in the first sacrificial pillar, and then the remaining first sacrificial pillar is removed and side etching is performed on the initial gate pillar, to form the target gate pillar, so as to obtain the gate conductive layer that is of the target gate pillar and that is on the third sidewall in contact with the channel region stacked layer, which can reduce an overlapping region between the gate conductive layer and the lightly doped drain region adjacent to two sides of the channel region stacked layer, and reduce impact of the GIDL effect. On the other hand, a process step for forming the gate conductive layer is less difficult to implement and highly feasible, and a structure with high device performance can be obtained without increasing excessive costs.

Based on the foregoing manufacturing method for a semiconductor device, the present disclosure further provides a semiconductor structure. As shown in any one of FIG. 10 to FIG. 14, the semiconductor structure includes at least a substrate 101 (201/301/401); a stacked structure 102 (202/302/402), formed by alternately stacking multiple semiconductor material layers 1022 (2022/3022/4022) and multiple insulating material layers 1021 (2021/3021/4021) and located on the substrate 101 (201/301/401), where the stacked structure 102 (202/302/402) includes at least a channel region stacked layer 1023 (2023/3023/4023) that extends in a Z direction perpendicular to a surface of the substrate 101 (201/301/401); and a target gate pillar 105' (205'/305'/405'), penetrating through the stacked structure 102 (202/302/402) in the Z direction, where the target gate pillar 105' (205'/305'/405') has a third sidewall in contact with the channel region stacked layer 1023 (2023/3023/4023), the target gate pillar 105' (205'/305'/405') includes a gate conductive layer 1052' (2052'/3052'/4052') located on the third sidewall and a gate dielectric layer 1051' (2051'/3051'/4051') located on an outer surface of the gate conductive layer 1052' (2052'/3052'/4052'), the gate conductive layer 1052' (2052'/3052'/4052') has a first length, the gate dielectric layer 1051' (2051'/3051'/4051') has a second length, and the first length is less than the second length. Length directions of the first length and the second length are both in an X direction, and the X direction is parallel to the surface of the substrate 101 (201/301/401) and a surface of each of the third sidewalls.

In some embodiments, in a Y direction, the channel region stacked layer 1023 (2023/3023/4023) and the target gate pillar 105' (205'/305'/405') are alternately arranged, and the Y direction is parallel to the surface of the substrate 101 (201/301/401) and perpendicular to the X direction.

In some embodiments, the same target gate pillar 105' (205'/305'/405') has two third sidewalls that are disposed opposite to each other and that are respectively in contact with two adjacent channel region stacked layers 1023 (2023/3023/4023), and the gate conductive layers located on the two opposite third sidewalls are isolated through a first insulating layer. In some embodiments, the first insulating layer includes a first insulating sublayer 1053 (2053/3053/4053) and a second insulating sublayer 1054 (2054/3054/4054).

In some embodiments, the channel region stacked layer 1023 (2023/3023/4023) further includes an oppositely doped channel region 1022a (2022a/3022a/4022a), and the oppositely doped channel region 1022a (2022a/3022a/4022a) is located in a region in which the channel region stacked layer 1023 (2023/3023/4023) is in contact with the third sidewall of the target gate pillar 105' (205'/305'/405'). The stacked structure 102 (202/302/402) further includes a lightly doped drain region stacked layer, and the lightly doped drain region stacked layer is adjacent to two sides that are of the channel region stacked layer 1023 (2023/3023/4023) and that are disposed opposite to each other in the X direction. The lightly doped drain region stacked layer further includes a lightly doped drain region 1022b (2022b/3022b/4022b), and an ion doping type of the lightly doped drain region 1022b (2022b/3022b/4022b) is opposite to that of the oppositely doped channel region 1022a (2022a/3022a/4022a). In some embodiments, a doped ion of the oppositely doped channel region 1022a may be a boron ion, and a doped ion of the lightly doped drain region 1022b (2022b/3022b/4022b) may be a phosphorus ion or an arsenic ion.

In some embodiments, referring to FIG. 11, the semiconductor structure further includes a second insulating layer 107 located on two sides that are of the target gate pillar 105' and that are disposed opposite to each other in the X direction. In some embodiments, the second insulating layer 107 is made of silicon oxide.

In some embodiments, referring to FIG. 12, the semiconductor structure further includes a second insulating layer 2072 and a third insulating layer 2071, where the third insulating layer 2071 is located between the second insulating layer 2072 and the substrate 201, the stacked structure 202, and the target gate pillar 205'. In some embodiments, the second insulating layer 2072 is made of silicon oxide, and the third insulating layer 2071 is made of silicon nitride.

In some embodiments, referring to FIG. 13, the semiconductor structure further includes an auxiliary gate layer 308, the auxiliary gate layer 308 is located on two sides of the gate conductive layer 3052' that is of the target gate pillar 305' and that is on the third sidewall, and a work function of the auxiliary gate layer 308 is less than a work function of the gate conductive layer 3052'. In some embodiments, the auxiliary gate layer 308 is made of doped polysilicon, and the gate conductive layer 3052' is made of titanium nitride.

In some embodiments, the semiconductor structure further includes a word line structure (not shown in the figure). The word line structure connects the gate conductive layers 1052' (2052'/3052'/4052'), on the third sidewalls, of two target gate pillars 105' (205'/305'/405') that are located on two sides, of the same channel region stacked layer 1023 (2023/3023/4023), disposed opposite to each other in the Y direction and that are in contact with the channel region stacked layer 1023 (2023/3023/4023). Specifically, the word line structures are in a one-to-one correspondence with the channel region stacked layers 1023 (2023/3023/4023), and two gate conductive layers 1052' (2052'/3052'/4052') that are closest to the corresponding channel region stacked layer 1023 (2023/3023/4023) are connected to each other. A main body of the word line structure is two gate conductive layers 1052' (2052'/3052'/4052') that are close to the same channel region stacked layer 1023 (2023/3023/4023), which jointly control turn-on or turn-off of the oppositely doped channel region 1022a (2022a/3022a/4022a) located in the same channel region stacked layer 1023 (2023/3023/4023).

In some embodiments, referring to FIG. 14, (c) in FIG. 14 is a top view facing the substrate 101 in a direction perpendicular to a surface of a substrate 401 (that is, a direction opposite to the Z direction). (a) in FIG. 14, (b) in FIG. 14, and (d) in FIG. 14 are respectively schematic diagrams along a cross-section A-A', along a cross-section B-B', and along a cross-section D-D' in (c) in FIG. 14, (e) in FIG. 14 is a schematic diagram along a cross-section E-E' in (d) in FIG. 14, and (f) in FIG. 14 is a partially enlarged schematic diagram of a region F (dashed box) in (e) in FIG. 14. The cross-section A-A' and the cross-section D-D' are parallel to the X direction and perpendicular to the Y direction, the cross-section B-B' is parallel to the Y direction and perpendicular to the X direction, and the cross-section E-E' is perpendicular to the Z direction. In an example embodiment of the present disclosure, the semiconductor structure further includes a bit line structure 409, a capacitor structure 410, and an insulating isolation layer 4024. The bit line structure 409 and the capacitor structure 410 are respectively located on two sides that are of the channel region stacked layer 4023 and that are disposed opposite to each other in the X direction, and the insulating isolation layer 4024 is located in the stacked structure 402, extends in the Z direction and the X direction, and penetrates through the stacked structure 402, to separate the channel region stacked layer 4023 and the semiconductor material layer 4022 in the Y direction. In some embodiments, the semiconductor material layer 4022 has a source drain region (not shown in the figure) at each of two ends disposed opposite to each other in the X direction, and a type of a doped ion of the source drain region is the same as that of the lightly doped drain region 4022b. In some embodiments, the bit line structure 409 is connected to a source drain region located at one end, disposed in the X direction, of each of the semiconductor material layers 4022 that are arranged at intervals in the Y direction and that are in the same horizontal layer, each capacitor structure 410 is correspondingly connected to a source drain region that is at the other end of each of the semiconductor material layers 4022 and that is disposed in the X direction, and each bit line structure 409 is configured to provide or sense, through the semiconductor material layer 4022, induced charges stored in or released from the capacitor structures 410 in the same horizontal layer. In some embodiments, each capacitor structure 410 further includes a first electrode layer 4101, a capacitor dielectric layer 4102, and a second electrode layer 4103 that are stacked in sequence. As shown in (d)/(e)/(f) in FIG. 14, the first electrode layer 4101 is in contact with the semiconductor material layer 4022, the capacitor dielectric layer 4102 is located on a surface of the first electrode layer 4101, and the second electrode layer 4103 is located on a surface of the capacitor dielectric layer 4102. In some embodiments, the first electrode layer 4101 and the second electrode layer 4103 may be made of any one or a combination of titanium nitride (TiN), titanium (Ti), and silicon-doped titanium nitride (TiSiN), and the capacitor dielectric layer 4102 may be made of at least one or a combination of zirconium oxide (ZrO₂) and aluminum oxide (Al₂O₃).

In some embodiments, a region in which the semiconductor material layer 4022 is in contact with the bit line structure 409 or the capacitor structure 410 further correspondingly includes a bit line contact layer (not shown in the figure) or a capacitor contact layer (not shown in the figure), to reduce a contact resistance at a contact interface. In some embodiments, a material of the bit line contact layer and/or the capacitor contact layer includes a metal silicide material such as cobalt silicide (CoSi), nickel silicide (NiSi), tungsten silicide (WSi), molybdenum silicide (MoSi), titanium silicide (TiSi), tantalum silicide (TaSi), ruthenium silicide (RuSi), and platinum silicide (PtSi).

In some embodiments, as shown in (f) in FIG. 14, (f) in FIG. 14 is a partially enlarged schematic diagram of a region F (dashed box) in (e) in FIG. 14, which may be understood as a partially enlarged schematic diagram of a basic storage unit structure in a semiconductor structure provided in an example embodiment of the present disclosure. The storage unit structure includes at least a transistor structure, that is, the semiconductor material layer 4022 isolated by the insulating isolation layer 4024; a word line structure (not shown in the figure), connecting gate conductive layers 4052'-1 and 4052'-2 that are on the third sidewalls adjacent to the channel region stacked layer 4023 and that are of the two target gate pillars located on two sides, of the same channel region stacked layer 4023, disposed opposite to each other in the Y direction, where in the Y direction, the gate conductive layers 4052'-1 and 4052'-2 have respective small projection overlapping regions or basically do not overlap with lightly doped drain regions 4022b-1 and 4022b-2 on two sides that are of the channel region stacked layer 4023 and that are disposed opposite to each other in the X direction. The bit line structure 409 and the capacitor structure 410 are respectively located at two ends of the semiconductor material layer 4022, and the two ends are disposed opposite to each other in the X direction. The capacitor structure 410 includes the first electrode layer 4101, the capacitor dielectric layer 4102, and the second electrode layer 4103 that are stacked in sequence.

Compared with a semiconductor structure in a related technology, the semiconductor structure provided in the present disclosure has a smaller overlapping region between the gate conductive layer, of the target gate pillar, located on the third sidewall and the lightly doped drain region adjacent to two sides of the channel region stacked layer, thereby reducing impact of a GIDL effect to some extent, and further improving operating performance of a memory device.

It should be noted that the semiconductor structure in embodiments of the present disclosure may be configured to manufacture a 3D DRAM device, or may be configured to manufacture another 3D device that needs to form metal semiconductor contact in the stacked structure. This is not limited herein.

Various semiconductor structures shown in the specific implementations may be employed in electronic devices with a storage function. The electronic device may be a terminal device, e.g., a mobile phone, a tablet computer, or a smart band, or may be a personal computer (personal computer, PC), a server, a workstation, or the like. The storage function in the electronic devices may be implemented by the following memory: a dynamic random access memory (DRAM), a ferroelectric random access memory (FRAM), a phase change memory (PCM), a magnetic random access memory (MRAM), or a resistive random access memory (RRAM).

The foregoing descriptions are merely specific implementations of the present disclosure, but are not intended to limit the protection scope of the present disclosure. Any variation or replacement readily figured out by a person skilled in the art within the technical scope disclosed in the present disclosure shall fall within the protection scope of the present disclosure. Therefore, the protection scope of the present disclosure shall be subject to the protection scope of the claims.

## Claims

1. A manufacturing method for a semiconductor structure, comprising:
providing a substrate (101, 201, 301, 401);
forming a stacked structure (102, 202, 302, 402) on the substrate (101, 201, 301, 401) by alternately stacking a plurality of semiconductor material layers (1022, 2022, 3022, 4022) and a plurality of insulating material layers (1021, 2021, 3021, 4021);
forming, in the stacked structure (102, 202, 302, 402), a channel region stacked layer (1023, 2023, 3023, 4023) and an initial gate pillar (105) that extend in a first direction perpendicular to a surface of the substrate (101, 201, 301, 401), the initial gate pillar (105) comprising at least an initial gate conductive layer (1052) and an initial gate dielectric layer (1051), and the initial gate pillar (105) having two first sidewalls that are disposed opposite to each other and that are respectively in contact with two adjacent channel region stacked layers (1023) and a second sidewall that is not in contact with any channel region stacked layer (1023); and
removing at least the initial gate dielectric layer (1051) and the initial gate conductive layer (1052) that are of the initial gate pillar (105) and that are located on the second sidewall, to form a target gate pillar (105', 205', 305', 405'), the target gate pillar (105', 205', 305', 405') comprising two third sidewalls that are disposed opposite to each other and that are respectively in contact with two adjacent channel region stacked layers (1023, 2023, 3023, 4023), and a gate conductive layer (1052', 2052', 3052', 4052') having a first length and a gate dielectric layer (1051', 2051', 3051', 4051') having a second length that are located on each of the third sidewalls, wherein the gate dielectric layer (1051', 2051', 3051', 4051') is located between the gate conductive layer (1052', 2052', 3052', 4052') and the channel region stacked layer (1023, 2023, 3023, 4023), the first length is less than the second length, length directions of the first length and the second length are both in a second direction, and the second direction is parallel to the surface of the substrate (101, 201, 301, 401) and a surface of each of the third sidewalls.

2. The manufacturing method for a semiconductor structure according to claim 1, wherein the forming, in the stacked structure (102, 202, 302, 402), a channel region stacked layer (1023, 2023, 3023, 4023) extending in a first direction perpendicular to a surface of the substrate (101, 201, 301, 401) comprises:
forming a plurality of first through holes (1030) in the stacked structure (102, 202, 302, 402), the plurality of first through holes (1030) extending in the first direction and penetrating through the stacked structure (102, 202, 302, 402), and being arranged at intervals in a third direction parallel to the surface of the substrate (101, 201, 301, 401), wherein the stacked structure (102, 202, 302, 402) between adjacent first through holes (1030) serves as the channel region stacked layer (1023, 2023, 3023, 4023), and the third direction and the second direction are perpendicular to each other.

3. The manufacturing method for a semiconductor structure according to claim 2, wherein the forming, in the stacked structure (102, 202, 302, 402), an initial gate pillar (105) extending in a first direction perpendicular to a surface of the substrate (101, 201, 301, 401) comprises:
filling a sacrificial material fully in a first through hole (1030), to form a first sacrificial pillar (103);
forming a first mask (1041) with a first opening (1040') on the stacked structure (102, 202, 302, 402), and etching along the first opening (1040') to form a second through hole (1040) in the first sacrificial pillar (103), the second through hole (1040) penetrating through the stacked structure (102, 202, 302, 402), wherein at least in the third direction, a size of the second through hole (1040) is basically the same as a size of the first through hole (1030); and
forming, in the second through hole (1040), the initial gate dielectric layer (1051), the initial gate conductive layer (1052), and a first insulating layer (1053, 1054) in sequence to form the initial gate pillar (105), wherein in the third direction, the initial gate pillar (105) has two opposite first sidewalls that are respectively in contact with two adjacent channel region stacked layers (1023, 2023, 3023, 4023), and in the second direction, the initial gate conductive layer (1052) that is of the initial gate pillar (105) and that is located on the first sidewall has a third length, the third length is greater than the first length, and the third length is greater than or equal to the second length.

4. The manufacturing method for a semiconductor structure according to claim 3, after the second through hole (1040) is formed and before the initial gate pillar (105) is formed in the second through hole (1040), further comprising:
performing ion implantation on the channel region stacked layer (1023, 2023, 3023, 4023) through the second through hole (1040), to form an oppositely doped channel region (1022a, 2022a, 3022a, 4022a).

5. The manufacturing method for a semiconductor structure according to claim 3, wherein the removing at least the initial gate dielectric layer (1051) and the initial gate conductive layer (1052) that are of the initial gate pillar (105) and that are located on the second sidewall, to form a target gate pillar (105', 205', 305', 405') comprises:
forming a second mask (1061) with a second opening (1060') on the stacked structure (102, 202, 302, 402), and etching along the second opening (1060') to form a third through hole (1060) in the first sacrificial pillar (103), the third through hole (1060) penetrating through the stacked structure (102, 202, 302, 402), and exposing the second sidewall of the initial gate pillar (105); and
removing, through the third through hole (1060), at least the initial gate dielectric layer (1051) and the initial gate conductive layer (1052) that are located on the second sidewall, to form the target gate pillar (105', 205', 305', 405'), wherein in the third direction, the target gate pillar (105', 205', 305', 405') has the two third sidewalls that are disposed opposite to each other and that are respectively in contact with two adjacent channel region stacked layers (1023, 2023, 3023, 4023).

6. The manufacturing method for a semiconductor structure according to claim 5, after the third through hole (1060) is formed and before at least the initial gate conductive layer (1052) located on the second sidewall is removed through the third through hole (1060), further comprising:
performing, through the third through hole (1060), ion implantation on the stacked structure (102, 202, 302, 402) adjacent to the channel region stacked layer (1023, 2023, 3023, 4023), to form a lightly doped drain region (1022b).

7. The manufacturing method for a semiconductor structure according to claim 5, after the target gate pillar (105', 205', 305', 405') is formed, further comprising: filling a second insulating layer (107, 2072, 307,407) in the third through hole (1060).

8. The manufacturing method for a semiconductor structure according to claim 7, after the target gate pillar (105', 205', 305', 405') is formed and before the second insulating layer (107, 2072, 307, 407) is filled in the third through hole (1060), further comprising:
forming an auxiliary gate layer (308) in the third through hole (1060), the auxiliary gate layer (308) being located at two ends of the gate conductive layer (3052'), wherein the two ends are disposed opposite to each other in the second direction, and a work function of the auxiliary gate layer (308) is less than a work function of the gate conductive layer (3052').

9. The manufacturing method for a semiconductor structure according to claim 2, after the target gate pillar (105', 205', 305', 405') is formed, further comprising:
connecting the gate conductive layers (1052', 2052', 3052', 4052') on the two third sidewalls that are located on two sides, of a same channel region stacked layer (1023, 2023, 3023, 4023), disposed opposite to each other in the third direction and that are in contact with the channel region stacked layers (1023, 2023, 3023, 4023), to form a word line structure.

10. The manufacturing method for a semiconductor structure according to any one of claims 1 to 9, after the stacked structure (102, 202, 302, 402) is formed, further comprising:
forming a bit line structure (409) and a capacitor structure (410), the bit line structure (409) and the capacitor structure (410) being respectively located at two ends of the channel region stacked layer (1023, 2023, 3023, 4023), wherein the two ends are disposed opposite to each other in the second direction.

11. A semiconductor structure, comprising:
a substrate (101, 201, 301, 401);
a stacked structure (102, 202, 302, 402), formed on the substrate (101, 201, 301, 401) by alternately stacking a plurality of semiconductor material layers (1022, 2022, 3022, 4022) and a plurality of insulating material layers (1021, 2021, 3021, 4021), the stacked structure (102, 202, 302, 402) further comprising at least a channel region stacked layer (1023, 2023, 3023, 4023) extending in a first direction perpendicular to a surface of the substrate (101, 201, 301, 401); and
a target gate pillar (105', 205', 305', 405'), penetrating through the stacked structure (102, 202, 302, 402) in the first direction, the target gate pillar (105', 205', 305', 405') comprising two third sidewalls that are disposed opposite to each other and that are respectively in contact with two adjacent channel region stacked layers (1023, 2023, 3023, 4023), and a gate conductive layer (1052', 2052', 3052', 4052') having a first length and a gate dielectric layer (1051', 2051', 3051', 4051') having a second length that are located on each of the third sidewalls, wherein the gate dielectric layer (1051', 2051', 3051', 4051') is located between the gate conductive layer (1052', 2052', 3052', 4052') and the channel region stacked layer (1023, 2023, 3023, 4023), the first length is less than the second length, length directions of the first length and the second length are both in a second direction, and the second direction is parallel to the surface of the substrate (101, 201, 301, 401) and a surface of each of the third sidewalls.

12. The semiconductor structure according to claim 11, wherein the channel region stacked layer (1023, 2023, 3023, 4023) and the target gate pillar (105', 205', 305', 405') are alternately arranged in a third direction, and the third direction is parallel to the surface of the substrate (101, 201, 301, 401) and perpendicular to the second direction.

13. The semiconductor structure according to claim 12, wherein the target gate pillar (105', 205', 305', 405') further comprises a first insulating layer (1053, 1054, 2053, 2054, 3053, 3054, 4053, 4054), and the gate conductive layers (1052', 2052', 3052', 4052') located on the two third sidewalls that are of a same target gate pillar (105', 205', 305', 405') and that are disposed opposite to each other in the third direction are isolated through the first insulating layer (1053, 1054, 2053, 2054, 3053, 3054, 4053, 4054).

14. The semiconductor structure according to claim 11, wherein the channel region stacked layer (1023, 2023, 3023, 4023) further comprises an oppositely doped channel region (1022a, 2022a, 3022a, 4022a), and the oppositely doped channel region (1022a, 2022a, 3022a, 4022a) is located in a region in which the channel region stacked layer (1023, 2023, 3023, 4023) is in contact with the third sidewall of the target gate pillar (105', 205', 305', 405'); and the stacked structure (102, 202, 302, 402) further comprises a lightly doped drain region (1022b, 2022b, 3022b, 4022b), the lightly doped drain region (1022b, 2022b, 3022b, 4022b) is adjacent to two sides that are of the channel region stacked layer (1023, 2023, 3023, 4023) and that are disposed opposite to each other in the second direction, and an ion doping type of the lightly doped drain region (1022b, 2022b, 3022b, 4022b) is opposite to that of the oppositely doped channel region (1022a, 2022a, 3022a, 4022a).

15. The semiconductor structure according to claim 11, further comprising an auxiliary gate layer (308), the auxiliary gate layer (308) being located on two sides that are of the gate conductive layer (3052') of the target gate pillar (305') on the third sidewall and that are disposed opposite to each other in the second direction, wherein a work function of the auxiliary gate layer (308) is less than a work function of the gate conductive layer (3052').

16. The semiconductor structure according to claim 12, further comprising:
a word line structure that connects the gate conductive layers (1052', 2052', 3052', 4052') on the two third sidewalls that are located on two sides, of a same channel region stacked layer (1023, 2023, 3023, 4023), disposed opposite to each other in the third direction and that are in contact with the channel region stacked layers (1023, 2023, 3023, 4023).

17. The semiconductor structure according to any one of claims 11 to 16, further comprising:
a bit line structure (409) and a capacitor structure (410), the bit line structure (409) and the capacitor structure (410) being respectively located on the two sides that are of the channel region stacked layer (1023, 2023, 3023, 4023) and that are disposed opposite to each other in the second direction.
